# EUROPEAN PATENT SPECIFICATION

(11) **EP 0 893 823 B1**
(45) Date of publication and mention of the grant of the patent: **02.05.2012**
(21) Application number: 98113868.8
(22) Date of filing: 24.07.1998
(51) Int. Cl.: H01L 21/56, H01L 23/29, H01L 23/482

(54) **Semiconductor bonding and sealing structure**
Struktur zum Bonden und Abdichten eines Halbleiters
Structure de liaison et de scellage d'un semiconducteur

(30) Priority: 25.07.1997 JP 21576997
(43) Date of publication of application: 27.01.1999
(73) Proprietor: Dow Corning Toray Co., Ltd., Tokyo (JP)
(72) Inventor: Isshiki, Minoru, Ichihara-shi, Chiba Prefecture (JP); Mine, Katsutoshi, Ichihara-shi, Chiba Prefecture (JP); Otani, Yoshiko, Ichihara-shi, Chiba Prefecture (JP); Yamakawa, Kimio, Ichihara-shi, Chiba Prefecture (JP)
(74) Representative: Polypatent

(56) References cited:
- EP-A- 0 260 360
- EP-A- 0 275 588
- EP-A- 0 412 608
- EP-A- 0 469 614
- US-A- 4 812 897
- US-A- 5 349 240
- TCHARKHTCHI A ET AL: "Viscoelastic properties of epoxy networks in the glass transition region" POLYMER, vol. 39, no. 5, March 1998, page 1233-1235 XP004101259
- KAZUNARI SUZUKI ET AL: "SILICONE DIE BOND ADHESIVE AND CLEAN IN-LINE CURE FOR COPPER LEAD FRAME" IEEE TRANSACTIONS ON COMPONENTS,HYBRIDS,AND MANUFACTURING TECHNOLOGY, vol. 13, no. 4, 1 December 1990, pages 883-887, XP000176835

## Description

This invention relates to semiconductor devices. More particularly, this invention relates to semiconductor devices in which the semiconductor chip is bonded by adhesive to a chip attachment element and at least a portion of the member that electrically connects said chip with the interconnects on said chip attachment element is sealed or embedded with a sealant/filling agent.

Japanese Patent Application Laid Open (PCT) Numbers Hei 6-504408 (504,408/1994) and Hei 8-504063 (504,063/1996) teach semiconductor devices in which the semiconductor chip is bonded by an adhesive to a chip attachment element and at least a portion of the member that electrically connects said chip with the interconnects on said chip attachment element is sealed or embedded with a sealant/filling agent.

While semiconductor devices of this type are characterized by their potential for miniaturization and by a relatively good resistance to thermal shock, additional improvements in their thermal shock resistance are nevertheless necessary.

The inventors achieved the present invention as a result of extensive investigations into the problems discussed above.

In specific terms, the object of the present invention is to provide a semiconductor device that has an excellent resistance to thermal shock.

With respect to a semiconductor device in which the semiconductor chip is bonded by an adhesive to a chip attachment element and at least a portion of the member that electrically connects said chip with the interconnects on said chip attachment element is sealed or embedded with a sealant/filling agent, the adhesive and the sealant/filling agent both being a cured silicone rubber. The semiconductor device according to the present invention is characterized in that the complex modulus of either or both of the said adhesive and said sealant/filling agent is no greater than 1 × 10⁸ Pa at -65 °C and a shear frequency of 10 Hz.
Figure 1 contains a cross-sectional diagram of an integrated circuit that is one example of a semiconductor device according to the present invention.
Figure 2 contains a cross-sectional diagram of an integrated circuit that is one example of a semiconductor device according to the present invention.

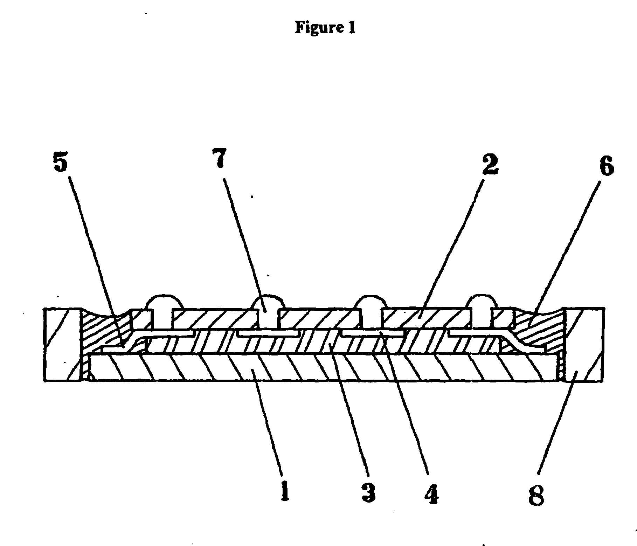

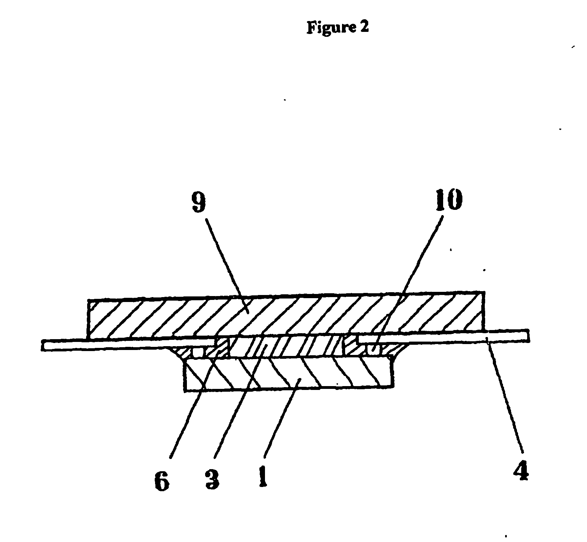

The semiconductor device according to the invention will be explained in detail. The semiconductor device according to the present invention comprises a semiconductor device in which the semiconductor chip is bonded by an adhesive to a chip attachment element and at least a portion of the member that electrically connects said chip with the interconnects on said chip attachment element is sealed or embedded with a sealant/filling agent. The semiconductor device according to the present invention can be exemplified by integrated circuits (ICs), large-scale integrated circuits (LSIs), and very large-scale integrated circuits (VLSIs). The semiconductor devices in Figures 1 and 2 are provided as examples of the semiconductor devices under consideration. The semiconductor device according to the present invention will be explained in detail in the following with reference to these figures.

In the semiconductor device shown in Figure 1, a semiconductor chip **1** faces a semiconductor chip attachment element **2** (a chip carrier in Figure 1) and is bonded thereto by adhesive **3**. Interconnects **4** are formed on the surface of the semiconductor chip attachment element **2** that faces the semiconductor chip **1**, and these interconnects **4** and the semiconductor chip **1** are electrically connected by leads **5**. A portion or all of the lead **5** is sealed or embedded with a sealant/filling agent **6**. In order to mount the semiconductor device shown in Figure 1 on a substrate, the semiconductor attachment element **2** is provided with solder balls **7**. In addition, an outer frame **8** is provided in order to protect the semiconductor chip **1** from external mechanical stresses, but the nature of this outer frame **8** in semiconductor devices according to the present invention is not critical.

In the semiconductor device shown in Figure 2, a semiconductor chip **1** faces a semiconductor chip attachment element **9** (a circuit substrate in Figure 2) and is bonded thereto by adhesive **3**. Interconnects **4** are formed on the surface of the semiconductor chip attachment element **9** that faces the semiconductor chip **1**, and these interconnects **4** and the semiconductor chip **1** are electrically connected by bumps **10**. A portion or all of the bump **10** is sealed or embedded with a sealant/filling agent **6**. In order to mount the semiconductor device shown in Figure 2 on a substrate, leads are provided that electrically connect to the interconnects **4**. Although not shown in Figure 2, the semiconductor chip **1** may be sealed with a resin sealant.

Neither the semiconductor chip nor the semiconductor chip attachment element are critical for the semiconductor device according to the present invention. The subject semiconductor chip attachment element can be made of for example, a ceramic such as alumina, glass, and the like; an organic resin such as epoxy resin, glass fiber-reinforced epoxy resin, polyimide resin, bismaleimide triazine resin, and the like; and metals such as stainless steel, copper, and the like. This element can be, for example, a rigid circuit substrate or chip carrier or a flexible circuit substrate or chip carrier. The interconnects can be formed on the surface of or within the semiconductor chip attachment element by such means as printing, vapor deposition, gluing, lamination, plating, and the like. In addition, outer connection terminals, such as a ball grid of solder balls or a pin grid, and other electrical elements and components may also be mounted or provided. Bonding wires, leads, and bumps are examples of the member that electrically connects the semiconductor chip with the interconnects on its semiconductor chip attachment element. In order to relax the stresses acting in this member when the semiconductor device is subjected to thermal stresses, the use is preferred for this member of curved, bent, or flexed bonding wires or leads, or of bumps made of material with a low Young's modulus.

Either or both of the adhesive bonding the semiconductor chip to its chip attachment element and the sealant/filling agent that seals or embeds the member that electrically connects the semiconductor chip with the interconnects on its chip attachment element must have a complex modulus, measured at -65 °C and a shear frequency of 10 Hz, no greater than 1 × 10⁸ Pa in the semiconductor device according to the present invention. The value of this complex modulus is preferably in the range from 1 × 10⁸ Pa to 1 × 10² Pa and more preferably is in the range from 1 × 10⁷ Pa to 1 × 10² Pa. The reason for specifying this range is that a semiconductor device fabricated using adhesive or sealant/filling agent with a complex modulus outside the specified range at -65 °C and a shear frequency of 10 Hz suffers from a reduced resistance to thermal shock. When a semiconductor device fabricated using such an adhesive or sealant/filling agent is subjected to thermal shock, the stresses generated by expansion and contraction due to differences in the thermal expansion coefficients among the semiconductor chip, its attachment element, and other structural members ultimately cause deformation and debonding of the members electrically connecting the semiconductor chip with the interconnects on its attachment element and warpage, deformation, and cracking of the semiconductor chip and hence in the reduced resistance to thermal shock. The complex modulus of the adhesive and sealant/filling agent at -65 °C and a shear frequency of 10 Hz can be determined by measurement on a strip or disk of the adhesive or sealant/filling agent using a dynamic viscoelastic test instrument.

The adhesive composition that forms the adhesive under consideration is a silicone adhesive composition.

In order to bond the semiconductor chip to its chip attachment element, the adhesive composition preferably takes the form of a liquid of suitably high viscosity, a grease, or a paste, or a sheet or film made of a B-stage adhesive or a hot-melt adhesive. The semiconductor chip can be bonded to its chip attachment element using the subject adhesive composition by, for example, heating the adhesive composition with a hot air current or thermal radiation, bringing the adhesive composition into contact with moist air, or irradiating the adhesive composition with UV radiation or an electron beam. The semiconductor chip in the semiconductor device according to the present invention is preferably bonded to the chip attachment element by the adhesive composition through the thermal cure of a thermosetting adhesive composition. Heating the subject adhesive composition forms a cured silicone that is a rubber at ambient temperature.

The sealant/filling agent composition that forms the sealant/filling agent under discussion is a silicone sealant/filling agent composition. In order to effect sealing or embedding of the member that electrically connects the semiconductor chip with the interconnects on the chip attachment element, the sealant/filling agent composition is preferably a paste or liquid and more preferably is a liquid. The member that electrically connects the semiconductor chip with the interconnects on the chip attachment element can be sealed or embedded using the subject sealant/filling agent composition by, for example, heating the sealant/filling agent composition with a hot air current or thermal radiation, bringing the composition into contact with moist air, or irradiating the composition with UV radiation or an electron beam. Sealing or embedding with an elastic sealant/filling agent composition is preferably effected in the semiconductor device according to the present invention through the thermal cure of a thermosetting sealant/filling agent composition. Heating the subject sealant/filling agent composition forms a cured silicone that is a rubber at ambient temperature.

The method for fabricating the semiconductor device according to the present invention is not critical. The semiconductor device shown in Figure 1 can be fabricated, for example, by setting up the opposing surfaces of the semiconductor chip **1** and the chip attachment element **2** next to each other with the adhesive composition (high-viscosity liquid, grease, paste, film, or sheet) sandwiched in between; curing the adhesive composition; then electrically connecting the semiconductor chip **1** and the interconnects **4** on the chip attachment element **2** with leads **5** (this connection step may also be carried out prior to curing the adhesive composition); sealing or embedding all or part of the lead **5** with a liquid sealant/filling agent composition; and subsequently curing the sealant/filling agent composition. The semiconductor device shown in Figure 2 can be fabricated by setting up the opposing surfaces of the semiconductor chip **1** and the chip attachment element **9** next to each other with the adhesive composition (high-viscosity liquid, grease, paste, film, or sheet) sandwiched in between; curing the adhesive composition; then electrically connecting the semiconductor chip **1** and the interconnects **4** on the chip attachment element **9** with bumps **10** (this connection step may also be carried out prior to curing the adhesive composition); sealing or embedding all or part of the bump **10** with a liquid sealant/filling agent composition; and subsequently curing the sealant/filling agent composition.

The nature of the contact between the subject adhesive and sealant/filling agent in the semiconductor device according to the present invention preferably ranges from bonding per se to acceptably intimate contact. Moreover, the nature of the contact between the sealant/filling agent and the member that electrically connects the semiconductor chip and the interconnects on the chip attachment element preferably also ranges from bonding per se to acceptably intimate contact.

The adhesive and sealant/filling agent in the semiconductor device according to the present invention can be electrically conductive, semiconductive, or nonconductive, although they are preferably semiconductive or nonconductive, for example, preferably with a volume resistivity at 25 °C of at least 1 × 10⁸ Ω·cm, when the surface of the semiconductor chip is used facing the chip attachment element.

### Examples

The semiconductor device according to the present invention will be explained in greater detail through working examples. In order to measure the complex modulus of the adhesive and sealant/filling agent at -65°C and a shear frequency of 10 Hz, a 12 mm × 50 mm × 2 mm strip of the cured product was prepared by heating the particular thermosetting silicone adhesive composition or thermosetting silicone sealant/filling agent composition at 150 °C for 30 minutes. The complex modulus was determined by measurement on this strip using a viscoelastic measurement instrument (a dynamic analyzer from Rheometrics, Inc.).

Semiconductors devices as shown in Figures 1 and 2 were fabricated as described below for use in the working examples of the invention and comparative examples.

### Fabrication of the semiconductor devices depicted in Figure 1

The opposing surfaces of the semiconductor chip **1** and semiconductor chip attachment element **2** were first set up facing each other with the thermosetting silicone adhesive composition sandwiched in between, and the semiconductor chip **1** and semiconductor chip attachment element **2** were then bonded to each other by curing the adhesive composition by heating at 150 °C for 30 minutes. The semiconductor chip **1** and interconnects **4** on the semiconductor chip attachment element **2** were then electrically connected by the leads **5**. Finally, each lead **5** was sealed or embedded in its entirety with the thermosetting silicone sealant/filling agent composition, and the sealant/filling agent composition was thereafter cured by heating for 30 minutes at 150 °C.

### Fabrication of the semiconductor devices depicted in Figure 2

The opposing surfaces of the semiconductor chip **1** and semiconductor chip attachment element **9** were first set up facing each other with the thermosetting silicone adhesive composition sandwiched in between, and the semiconductor chip **1** and semiconductor chip attachment element **9** were then bonded to each other by curing the adhesive composition by heating at 150 °C for 30 minutes. The semiconductor chip **1** and interconnects **4** on the semiconductor chip attachment element **9** were then electrically connected by the bumps **10**. Finally, each bump **10** was sealed or embedded in its entirety with the thermosetting silicone sealant/filling agent composition, and the sealant/filling agent composition was thereafter cured by heating for 30 minutes at 150 °C.

The thermal shock resistance of the semiconductor devices fabricated as described above was evaluated as follows.

Evaluation of the thermal shock resistance of the semiconductor devices Twenty semiconductor devices were submitted to thermal shock testing in which 1 cycle consisted of standing for 30 minutes at -65 °C and standing for 30 minutes at +150 °C. The percentage of defective semiconductor devices was determined after 1,000 cycles and 3,000 cycles by continuity testing, using the solder balls **7** on the semiconductor chip attachment element **2** (chip carrier) in the case of semiconductor devices according to Figure 1 and using the interconnects **4** in the case of the semiconductor devices according to Figure 2.

The adherence between the adhesive and sealant/filling agent in the semiconductor devices was evaluated as follows.

### Evaluation of the adherence between the adhesive and sealant/filling agent

After the semiconductor device had been subjected to 3,000 cycles in the thermal shock test, the adherence between the adhesive **3** and sealant/filling agent **6** was investigated using an optical microscope at 10X. The adhesiveness was evaluated on the following scale: + = tight bonding, Δ = partial debonding, × = complete debonding.

### Example 1

The adhesive composition used in this example was a thermosetting silicone adhesive composition grease that formed an adherent silicone rubber upon heating. This composition provided a silicone rubber that had a volume resistivity at 25°C of 1.0 × 10¹⁵ Ω·cm and a complex modulus of 2.0 × 10⁶ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 2.0 × 10⁶ Pa at -65 °C and a shear frequency of 10 Hz. This adhesive composition and sealant/filling agent composition were used to fabricate 20 semiconductor devices as shown in Figure 1. The resulting semiconductor devices were evaluated for thermal shock resistance and for adherence between the adhesive and sealant/filling agent. The results of these evaluations are reported in Table 1.

### Example 2

The adhesive composition used in this example was a thermosetting silicone adhesive composition grease that formed an adherent silicone rubber upon heating. This composition provided a silicone rubber that had a volume resistivity at 25 °C of 1.0 × 10¹⁵ Ω·cm and a complex modulus of 1.5 × 10⁸ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 2.0 × 10⁶ Pa at -65 °C and a shear frequency of 10 Hz. This adhesive composition and sealant/filling agent composition were used to fabricate 20 semiconductor devices as shown in Figure 1. The resulting semiconductor devices were evaluated for thermal shock resistance and for adherence between the adhesive and sealant/filling agent. The results of these evaluations are reported in Table 1.

### Example 3

A sheet of semicured thermosetting silicone adhesive that formed an adherent silicone rubber upon heating was used to form the adhesive in this example. The resulting silicone rubber had a volume resistivity at 25 °C of 1.0 × 10¹⁵ Ω·cm and a complex modulus of 2.0 × 10⁶ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 2.0 × 10⁶ Pa at -65 °C and a shear frequency of 10 Hz. This adhesive sheet and sealant/filling agent composition were used to fabricate 20 semiconductor devices as shown in Figure 1. The resulting semiconductor devices were evaluated for thermal shock resistance and for adherence between the adhesive and sealant/filling agent. The results of these evaluations are reported in Table 1.

### Example 4

A sheet of semicured thermosetting silicone adhesive that formed an adherent silicone rubber upon heating was used to form the adhesive in this example. The resulting silicone rubber had a volume resistivity at 25 °C of 1.0 × 10¹⁵ Ω·cm and a complex modulus of 1.5 × 10⁸ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 2.0 × 10⁶ Pa at -65 °C and a shear frequency of 10 Hz. This adhesive sheet and sealant/filling agent composition were used to fabricate 20 semiconductor devices as shown in Figure 1. The resulting semiconductor devices were evaluated for thermal shock resistance and for adherence between the adhesive and sealant/filling agent. The results of these evaluations are reported in Table 1.

### Example 5

The adhesive composition used in this example was a thermosetting silicone adhesive composition grease that formed an adherent silicone rubber upon heating. This composition provided a silicone rubber that had a volume resistivity at 25 °C of 1.0 × 10¹⁵ Ω·cm and a complex modulus of 2.0 × 10⁶ Pa at 65°C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 2.0 × 10⁶ Pa at -65 °C and a shear frequency of 10 Hz. This adhesive composition and sealant/filling agent composition were used to fabricate 20 semiconductor devices as shown in Figure 2. The resulting semiconductor devices were evaluated for thermal shock resistance and for adherence between the adhesive and sealant/filling agent. The results of these evaluations are reported in Table 1.

### Example 6

The adhesive composition used in this example was a thermosetting silicone adhesive composition grease that formed an adherent silicone rubber upon heating. This composition provided a silicone rubber that had a volume resistivity at 25°C of 1.0 × 10¹⁵ Ω·cm and a complex modulus of 1.5 × 10⁸ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25°C of 1.0 × 10¹⁵ Ω·cm and a complex modulus of 2.0 × 10⁶ Pa at -65 °C and a shear frequency of 10 Hz. This adhesive composition and sealant/filling agent composition were used to fabricate 20 semiconductor devices as shown in Figure 2. The resulting semiconductor devices were evaluated for thermal shock resistance and for adherence between the adhesive and sealant/filling agent. The results of these evaluations are reported in Table 1.

### Example 7

A sheet of semicured thermosetting silicone adhesive that formed an adherent silicone rubber upon heating was used to form the adhesive in this example. The resulting silicone rubber had a volume resistivity at 25 °C of 1.0 × 10¹⁵ Ω·cm and a complex modulus of 2.0 × 10⁶ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 2.0 × 10⁶ Pa at -65 °C and a shear frequency of 10 Hz. This adhesive sheet and sealant/filling agent composition were used to fabricate 20 semiconductor devices as shown in Figure 2. The resulting semiconductor devices were evaluated for thermal shock resistance and for adherence between the adhesive and sealant/filling agent. The results of these evaluations are reported in Table 1.

### Example 8

A sheet of semicured thermosetting silicone adhesive that formed an adherent silicone rubber upon heating was used to form the adhesive in this example. The resulting silicone rubber had a volume resistivity at 25 °C of 1.0 × 10¹⁵ Ω·cm and a complex modulus of 1.5 × 10⁸ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 2.0 × 10⁶ Pa at -65 °C and a shear frequency of 10 Hz. This adhesive sheet and sealant/filling agent composition were used to fabricate 20 semiconductor devices as shown in Figure 2. The resulting semiconductor devices were evaluated for thermal shock resistance and for adherence between the adhesive and sealant/filling agent. The results of these evaluations are reported in Table 1.

### Comparative Example 1

A sheet of semicured thermosetting silicone adhesive that formed an adherent silicone rubber upon heating was used to form the adhesive in this comparative example. The resulting silicone rubber had a volume resistivity at 25 °C of 1.0 × 10¹⁵ Ω·cm and a complex modulus of 1.5 × 10⁸ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 1.5 × 10⁸ Pa at -65° C and a shear frequency of 10 Hz. This adhesive sheet and sealant/filling agent composition were used to fabricate 20 semiconductor devices as shown in Figure 1. The resulting semiconductor devices were evaluated for thermal shock resistance and for adherence between the adhesive and sealant/filling agent. The results of these evaluations are reported in Table 1.

### Comparative Example 2

The adhesive composition used in this comparative example was a thermosetting silicone adhesive composition grease that formed an adherent silicone rubber upon heating. This composition provided a silicone rubber that had a volume resistivity at 25 °C of 1.0 × 10¹⁵ Ω·cm and a complex modulus of 1.5 × 10⁸ Pa at -65 °C and a shear frequency of 10 Hz. The sealant/filling agent composition used to form the sealant/filling agent was a liquid thermosetting silicone sealant/filling agent composition that cured upon heating with the formation of a silicone rubber. This composition provided a silicone rubber that had a volume resistivity at 25 °C of 1.0 × 10¹⁵ Ω·cm and a complex modulus of 1.5 × 10⁸ Pa at -65 °C and a shear frequency of 10 Hz. This adhesive composition and sealant/filling agent composition were used to fabricate 20 semiconductor devices as shown in Figure 1. The resulting semiconductor devices were evaluated for thermal shock resistance and for adherence between the adhesive and sealant/filling agent. The results of these evaluations are reported in Table 1.

### Comparative Example 3

A sheet of semicured thermosetting silicone adhesive that formed an adherent silicone rubber upon heating was used to form the adhesive in this comparative example. The resulting silicone rubber had a volume resistivity at 25 °C of 1.0 × 10¹⁵ Ω·cm and a complex modulus of 1.5 × 10⁸ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 1.5 × 10⁸ Pa at -65 °C and a shear frequency of 10 Hz. This adhesive sheet and sealant/filling agent composition were used to fabricate 20 semiconductor devices as shown in Figure 2. The resulting semiconductor devices were evaluated for thermal shock resistance and for adherence between the adhesive and sealant/filling agent. The results of these evaluations are reported in Table 1.

### Comparative Example 4

The adhesive composition used in this comparative example was a thermosetting silicone adhesive composition grease that formed an adherent silicone rubber upon heating. This composition provided a silicone rubber that had a volume resistivity at 25 °C of 1.0 × 10¹⁵ Ω·cm and a complex modulus of 1.5 × 10⁸ Pa at -65 °C and a shear frequency of 10 Hz. The sealant/filling agent composition used to form the sealant/filling agent was a liquid thermosetting silicone sealant/filling agent composition that formed an adherent silicone rubber upon heating. This composition provided a silicone rubber that had a volume resistivity at 25 °C of 1.0 × 10¹⁵ Ω·cm and a complex modulus of 1.5 × 10⁸ Pa at -65 °C and a shear frequency of 10 Hz. This adhesive composition and sealant/filling agent composition were used to fabricate 20 semiconductor devices as shown in Figure 2. The resulting semiconductor devices were evaluated for thermal shock resistance and for adherence between the adhesive and sealant/filling agent. The results of these evaluations are reported in Table 1.

**Table 1**

| | | | working examples | | | | | | | | comparative examples | | | |
|---|---|---|---|---|---|---|---|---|---|---|---|---|---|---|
| | | | 1 | 2 | 3 | 4 | 5 | 6 | 7 | 8 | 1 | 2 | 3 | 4 |
| thermal shock resistance of the semiconductor devices | | | | | | | | | | | | | | |
| | | | | | | | | | | | | | | |
| % defective semiconductor devices | | | | | | | | | | | | | | |
| after | | 1,000 cycles | 0 | 0 | 0 | 0 | 0 | 0 | 0 | 0 | 0 | 0 | 0 | 0 |
| | | 3,000 cycles | 0 | 5 | 0 | 5 | 0 | 5 | 5 | 5 | 30 | 50 | 25 | 30 |
| adherence between the adhesive and sealant/filling agent | | | Δ | Δ | + | + | Δ | Δ | + | + | + | × | + | × |

The semiconductor device according to the present invention is characterized by an excellent resistance to thermal shock.

## Claims

1. A semiconductor device, comprising: a semiconductor chip (1); a semiconductor chip attachment element (2,9) facing the semiconductor chip (1), at least one interconnect (4) on the surface of the semiconductor chip attachment element (2,9); and at least one member that electrically connects the semiconductor chip (1) with the interconnects (4); wherein the semiconductor chip (1) is bonded to the semiconductor chip attachment element (2,9) by an adhesive (3) which directly contacts said surface of the semiconductor chip attachment element (2,9) and at least a portion of at least one member that electrically connects the semiconductor chip (1) with at least one interconnect (4) is sealed or imbedded with a sealant/fitting agent (6), and both the adhesive (3) and the sealant/filling agent (6) is a cured silicone rubber, wherein at least one of the adhesive (3) and the sealant/filling agent (6) has a complex modulus not greater than 1 × 10⁸ Pa at -65 °C and a shear frequency of 10 Hz.

2. The semiconductor device according to claim 1, wherein the semiconductor device is an integrated circuit, large-scale integrated circuit, or a very large-scale integrated circuit.

3. The semiconductor device according to claim 1, wherein the member that electrically connects the semiconductor chip (1) with the interconnects (4) is a bonding wire, a lead (5), or a bump (10).

4. The semiconductor device according to claim 1, wherein the complex modulus of a both the adhesive (3) and the sealant/filling agent (6) is not greater than 1 × 10⁸ Pa at -65 °C and a shear frequency of 10 Hz.

5. The semiconductor device according to claim 1, wherein the complex modulus is from 1 × 10⁸ to 1 × 10² Pa.

6. The semiconductor device according to claim 5, wherein the complex modulus is from 1 × 10⁷ to 1 × 10² Pa.

7. The semiconductor device according to claim 1, wherein the semiconductor chip (1) is bonded to the semiconductor chip attachment element (2,9) by curing a thermosetting adhesive composition.

8. The semiconductor device according to a claim 1, wherein the member that electrically connects the semiconductor chip (1) with the interconnects (4) is sealed or embedded by curing a thermosetting sealant/fllling agent compositlon.

9. The semiconductor device according to claim 1, wherein the sealant/filllng agent is electrically conductive, semiconductive, or nonconductive.

10. The semiconductor device according to claim 9, wherein the sealant/filling agent (6) is semiconductive or nonconductive.

11. The semiconductor device according to claim 10, wherein the sealant/filling agent (6) has a volume resistivity of at least 1 × 10⁶ ohm-cm at 25°C.

12. The semiconductor device according to claim 1, wherein the adhesive (3) is electrically conductive, semiconductive, or nonconductive.

13. The semiconductor device according to claim 10, wherein the adhesive has a volume resistivity of at least 1 x 10⁸ ohm-cm at 25°C.

## Patentansprüche

1. Halbleitervorrichtung enthaltend:
einen Halbleiterchip (1), ein dem Halbleiterchip (1) gegenüberliegendes Halbleiterchipbefestigungselement (2,9), wenigstens eine Verbindung (4) auf der Oberfläche des Halbleiterchipbefestigungselements (2,9) und wenigstens ein Teil, das den Halbleiterchip (1) mit den Verbindungen (4) elektrisch verbindet, wobei der Halbleiterchip (1) mit dem Halbleiterchipbefestigungselement (2,9) durch einen Klebstoff (3) verbunden ist, der unmittelbar die Oberfläche des Halbleiterchipbefestigungselements (2,9) kontaktiert, und wenigstens einen Teil wenigstens eines Teils, das den Halbleiterchip (1) mit der wenigstens einen Verbindung (4) elektrisch verbindet, mit einem Versiegelungsmittel/Füllmittel (6) versiegelt oder darin eingebettet ist und sowohl der Klebstoff (3) als auch das Versiegelungsmittel/Füllmittel (6) ein gehärteter Siliconkautschuk ist, wobei wenigstens einer von dem Klebstoff (3) und dem Versiegelungsmittel/Füllmittel (6) einen komplexen Modul von nicht größer als 1 x 10⁸ Pa bei -65°C und einer Scherfrequenz von 10 Hz aufweist.

2. Halbleitervorrichtung gemäß Anspruch 1, wobei die Halbleitervorrichtung ein integrierter Schaltkreis, ein hochintegrierter Schaltkreis oder ein höchstintegrierter Schaltkreis ist.

3. Halbleitervorrichtung gemäß Anspruch 1, wobei das Teil, das den Halbleiterchip (1) mit den Verbindungen (4) verbindet, ein Bonddraht, eine Leitung (5) oder ein Kontakthöcker (10) ist.

4. Halblsitervorrichtung gemäß Anspruch 1, wobei der komplexe Modul sowohl des Klebstoffs (3) als auch des Versiegelungsmittels/Füllmittels (6) nicht größer als 1 x 10⁸ Pa bei -65°C und einer Scherfrequenz von 10 Hz ist.

5. Halbleitervorrichtung gemäß Anspruch 1, wobei der komplexe Modul von 1 x 10⁸ bis 1 x 10² Pa beträgt.

6. Halbleitervorrichtung gemäß Anspruch 5, wobei der komplexe Modul von 1 x 10⁷ bis 1 x 10² Pa beträgt.

7. Halbleitervorrichtung gemäß Anspruch 1, wobei der Halbleiterchip (1) an das Halbleiterchipbefestigungselement (2,9) durch Härten einer wärmehärtenden Klebstoffzusammensetzung gebunden ist.

8. Halbleitervorrichtung gemäß Anspruch 1, wobei das Teil, das den Halbleiterchip (1) elektrisch mit den Verbindungen (4) verbindet, durch Härten einer wärmehärtenden Versiegelungsmittel/Füllmittelzusammensetzung versiegelt oder darin eingebettet ist.

9. Halbleitervorrichtung gemäß Anspruch 1, wobei das Versiegelungsmittel/Füllmittel elektrisch leitfähig, halbleitend oder nichtleitend ist.

10. Halbleitervorrichtung gemäß Anspruch 9, wobei das Versiegelungsmittel/Füllmittel (6) halbleitend oder nichtleitend ist.

11. Halbleitervorrichtung gemäß Anspruch 10, wobei das Versiegelungsmittel/Füllmittel (6) einen Volumenwiderstand von wenigstens 1 x 10⁸ Ω·cm bei 25°C aufweist.

12. Halbleitervorrichtung gemäß Anspruch 1, wobei der Klebstoff (3) elektrisch leitfähig, halbleitend oder nichtleitend ist.

13. Halbleitervorrichtung gemäß Anspruch 10, wobei der Klebstoff einen Volumenwiderstand von wenigstens 1 x 10⁸ Ω·cm bei 25°C aufweist.

## Revendications

1. Dispositif à semi-conducteur, comprenant : une puce à semi-conducteur (1) ; un élément de fixation de puce à semi-conducteur (2, 9) faisant face à la puce à semi-conducteur (1), au moins une interconnexion (4) sur la surface de l'élément de fixation de la puce à semi-conducteur (2, 9) ; et au moins un élément qui connecte électriquement la puce à semi-conducteur (1) avec les interconnexions (4) ; dans lequel la puce à semi-conducteur (1) est liée à l'élément de fixation de la puce à semi-conducteur (2, 9) par un adhésif (3) qui est directement en contact avec ladite surface de l'élément de fixation de la puce à semi-conducteur (2, 9) et au moins une partie d'au moins un élément qui connecte électriquement la puce à semi-conducteur (1) avec au moins une interconnexion (4) est scellée ou enrobée avec un agent d'étanchéité/de remplissage (6), l'adhésif (3) et l'agent d'étanchéité/de remplissage (6) étant tous deux un caoutchouc de silicone durci, au moins un de l'adhésif (3) et de l'agent d'étanchéité/de remplissage (6) ayant un module complexe ne dépassant pas 1 x 10⁸ Pa à -65°C et une fréquence de cisaillement de 10 Hz.

2. Dispositif à semi-conducteur selon la revendication 1, le dispositif à semi-conducteur étant un circuit intégré, un circuit intégré à grande échelle ou un circuit intégré à très grande échelle.

3. Dispositif à semi-conducteur selon la revendication 1, dans lequel l'élément qui connecte électriquement la puce à semi-conducteur (1) avec les Interconnexions (4) est un fil de connexion, un fil conducteur (5) ou une bosse (10).

4. Dispositif à semi-conducteur selon la revendication 1, dans lequel le module complexe d'à la fois l'adhésif (3) et l'agent d'étanchéité/de remplissage (6) ne dépasse pas 1 x 10⁸ Pa à -65°C et une fréquence de cisaillement de 10 Hz.

5. Dispositif à semi-conducteur selon la revendication 1, dans lequel le module complexe va de 1 x 10⁸ à 1 x 10² Pa.

6. Dispositif à semi-conducteur selon la revendication 5, dans lequel le module complexe va de 1 x 10⁷ à 1 x 10² Pa.

7. Dispositif à semi-conducteur selon la revendication 1, dans lequel la puce à semi-conducteur (1) est liée à l'élément de fixation de puce à semi-conducteur (2, 9) par durcissement d'une composition adhésive thermodurcissable.

8. Dispositif à semi-conducteur selon la revendication 1, dans lequel l'élément qui connecte électriquement la puce à semi-conducteur (1) avec les interconnexions (4) est scellé ou enrobé par durcissement d'une composition d'agent d'étanchéité/de remplissage thermodurcissable.

9. Dispositif à semi-conducteur selon la revendication 1, dans lequel l'agent d'étanchéité/de remplissage est électroconducteur, semi-conducteur ou non conducteur.

10. Dispositif à semi-conducteur selon la revendication 9, dans lequel l'agent d'étanchéité/de remplissage (6) est semi-conducteur ou non conducteur.

11. Dispositif à semi-conducteur selon la revendication 10, dans lequel l'agent d'étanchéité/de remplissage (6) a une résistivité volumique d'au moins 1 x 10⁸ ohm-cm à 25°C.

12. Dispositif à semi-conducteur selon la revendication 1, dans lequel l'adhésif (3) est électroconducteur, semi-conducteur ou non conducteur.

13. Dispositif à semi-conducteur selon la revendication 10, dans lequel l'adhésif a une résistivité volumique d'au moins 1 x 10⁸ ohm-cm à 25°C.
